(19) Europäisches Patentamt
European Patent Office
Office européen des brevets

(11) Veröffentlichungsnummer: **0 087 169**
**B1**

(12) # EUROPÄISCHE PATENTSCHRIFT

(45) Veröffentlichungstag der Patentschrift: **11.06.86**

(51) Int. Cl.⁴: **G 03 F 7/26**, C 08 F 220/22

(21) Anmeldenummer: **83101822.1**

(22) Anmeldetag: **24.02.83**

(54) **Positives Resistmaterial.**

(30) Priorität: **24.02.82 DE 3206633**
**17.12.82 DE 3246825**

(43) Veröffentlichungstag der Anmeldung:
**31.08.83 Patentblatt 83/35**

(45) Bekanntmachung des Hinweises auf die Patenterteilung:
**11.06.86 Patentblatt 86/24**

(84) Benannte Vertragsstaaten:
**AT BE CH DE FR GB IT LI LU NL SE**

(56) Entgegenhaltungen:
**EP-A-0 006 938**
**EP-A-0 016 679**
**DE-A-3 036 615**
**DE-B-2 702 427**

(73) Patentinhaber: **Max-Planck-Gesellschaft zur Förderung der Wissenschaften e.V., Bunsenstrasse 10, D-3400 Göttingen (DE)**

(72) Erfinder: **Asmussen, Frithjof, Dr., Am Wieselbau 14, D-1000 Berlin 37 (DE)**
Erfinder: **Sotobayashi, Hideto, Prof., Dr., Enzianstrasse 1, D-1000 Berlin 45 (DE)**
Erfinder: **Chen, Dr. Jiang-Tsun, Ortolanweg 42, D-1000 Berlin 47 (DE)**
Erfinder: **Schnabel, Wolfram, Prof. Dr., Krottnaurer Strasse 11, D-1000 Berlin 38 (DE)**

(74) Vertreter: **Weickmann, Heinrich, Dipl.-Ing. et al, Patentanwälte Dipl.-Ing. H.Weickmann Dipl.-Phys.Dr. K.Fincke Dipl.-Ing. F.A.Weickmann Dipl.-Chem. B. Huber Dr.-Ing. H. Liska Dipl.-Phys.Dr. J. Prechtel Postfach 860820, D-8000 München 86 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

LIBER, STOCKHOLM 1986

EP 0 087 169 B1

## Beschreibung

Die Erfindung betrifft ein positives, thermisch vernetzbares Resistmaterial.

Resists bilden strahlenempfindliche Filme, deren Löslichkeit sich bei Belichtung mit energiereicher Strahlung ändert. Man unterscheidet zweierlei resist-Typen, je nachdem, ob die Löslichkeit der Filmschichten verringert ("negativ-resists") oder vergrößert wird ("positivresists). Im ersteren Fall werden nach dem Belichten die unbelichteten Teile mit einem geeigneten Lösungsmittel entfernt, im zweiten Fall die belichteten Teile. Die Resists werden auf die Werkstoffoberfläche in dünner Schicht aufgebracht und dienen nach der z. B. durch eine Maskenvorlage vorgenommenen Belichtung und dem Auswaschprozeß (Entwickeln) zur Strukturierung von Werkstoffoberflächen, z. B. durch Ätzen oder Galvanisieren. Resists werden insbesondere in der Halbleitertechnologie (very large scale integration = VLSI), bei der Fertigung von elektronischen Bausteinen (gedruckte Schaltungen, integrierte Schaltkreise) und in der Drucktechnik (Herstellung von Siebdruckformen) verwendet.

Zur Übertragung von kleinsten Strukturen, z. B. auf Halbleiterbauelemente für die Mikroelektronik, sind bereits eine Reihe von Resists bekannt. In der US-PS 3 535 137 und in der US-PS 3 779 806 werden Polymethacrylsäureester als Resists beschrieben, mit denen mittels Elektronenstrahlen ein vorgegebenes Muster auf ein Substrat übertragen werden kann. Aus der DE-OS 2 610 301 ist ein positiv wirkender, thermisch vernetzbarer Resist bekannt, der ein Alkylmethacrylat-Methacrylsäurechlorid-Copolymeres enthält. Ein Nachteil dieser Resists auf Basis Polymethacrylsäureester oder Alkylmethacrylat-Methacrylsäurechlorid-Copolymerer ist die geringe Empfindlichkeit. Aus DE-OS 2 702 427, JA-PS 55-24088 und JA-PS 53-100774 sind Resists auf Basis halogenierter Polymethacrylsäureester bekannt, die zwar gegenüber energiereicher Strahlung eine höhere Empfindlichkeit besitzen, die aber keine befriedigende Haftfestigkeit auf dem Substrat aufweisen. Aus der EP-A-0006938 ist ein positiv wirkender, thermisch vernetzbarer Resist aus einem Copolymeren aus einem (Halogen)alkylacrylat, einer monoolefinisch ungesättigten Carbonsäure und Methacrylsäurechlorid bekannt. Die EP-A-00166 79 beschreibt Positivresists aus Copolymeren von halogenierten α-Alkylacrylsäureestern; als Entwickler werden Lösungsmittelgemische verwendet.

Der Erfindung liegt deshalb die Aufgabe zugrunde, die bekannten Nachteile zu überwinden und einen Resist bereitzustellen, der eine Kombination spezieller gewünschter Resisteigenschaften aufweist und insbesondere neben einer hohen Empfindlichkeit gegenüber Strahlung auch eine ausreichende mechanische Stabilität und Haftfestigkeit auf dem Substrat besitzt. Diese Aufgabe wird mit der vorliegenden Erfindung gelöst.

Gegenstand der Erfindung ist ein positives Resistmaterial bestehend aus einem in einem organischen Lösungsmittel löslichen, thermisch vernetzbaren Copolymeren aus Fluoralkylmethacrylat und Chloralkylmethacrylat, das dadurch gekennzeichnet ist, daß das Copolymere die allgemeine Formel

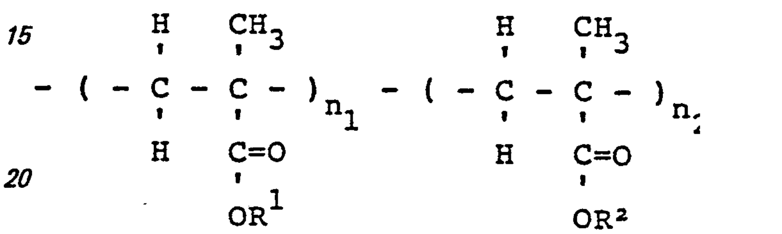

besitzt, worin $R^1$ eine ganz oder teilweise fluorierte Alkylgruppe mit 2 bis 6 Kohlenstoffatomen, $R^2$ eine teilweise chlorierte Alkylgruppe mit 2 bis 6 Kohlenstoffatomen und einer ω-Trichlormethylgruppe darstellt, der Polymerisationsgrad $n = n_1 + n_2$ zwischen 300 und 3000 und der Molenbruch $n_2/n$ zwischen 0,02 und 0,20 liegt.

Eine fluorierte Alkylgruppe $R^1$ kann ganz oder teilweise fluoriert sein und verzweigt oder vorzugsweise geradkettig sein. Sie ist insbesondere eine Hexafluoralkylgruppe und in erster Linie 2, 2, 3, 4, 4, 4-Hexa-fluorbutyl.

Eine teilweise chlorierte Alkylgruppe $R^2$ mit einer terminalen ω-Trichlormethylgruppe kann verzweigt oder vorzugsweise geradkettig sein. Sie ist zum Beispiel 2, 2, 2-Trichloräthyl.

Die Copolymeren sind statistisch aus den Comonomeren zusammengesetzt.

Bei der thermischen Behandlung können die Resists unter Bildung intermolekularer Bindungen so weit vernetzt werden, daß sie für einen bestimmten Entwickler unlöslich werden. Der Vernetzungsgrad wird dabei durch die Temperatur und die Zeit der thermischen Vernetzung sowie durch die Konzentration der vernetzbaren Gruppen bestimmt. In der Regel liegt die Vernetzungstemperatur zwischen 180 und 250°C und die Zeit zwischen 30 und 90 Minuten.

Aus einer Veröffentlichung von T. Tada (J. Electrochem. Soc. 126, 1635 (1979) ist es bekannt, daß sich Poly-2, 2, 2-trichloräthylmethacrylat durch thermische Behandlung chemisch vernetzen läßt, und daß dadurch die mechanischen Eigenschaften verändert und die Löslichkeit in Lösungsmitteln verschlechtert werden. Die vollständige, alle Makromoleküle

umfassende Vernetzung bewirkt Unlöslichkeit und eine starke Haftung des Resists auf dem Substrat. Der Mechanismus der Vernetzung ist bisher nicht geklärt.

Die Resistlösung kann erfindungsgemäß dadurch erhalten werden, daß man das Copolymere in einem inerten organischen Lösungsmittel löst. Als Lösungsmittel kann jedes die erfindungsgemäßen Copolymeren lösende inerte organische Lösungsmittel verwendet werden; bevorzugt wird als Lösungsmittel Methyläthylketon, Methylisobutylketon und/oder Butylacetat verwendet. Die Lösung erfolgt vorzugsweise bei Raumtemperatur oder schwach erhöhter Temperatur. Die Konzentration des Copolymeren im Lösungsmittel beträgt vorzugsweise 5 bis 20 Gew.-%.

Zur Verwendung des erfindungsgemäßen Resistmaterials als "positiv-resist" zur Strukturierung von Werkstoffoberflächen, die einen weiteren Gegenstand der Erfindung darstellt, geht man zweckmäßigerweise so vor, daß man es in dünner Schicht, vorzugsweise mit einer Dicke von 0,3 bis 3,0 µm auf dem Substrat aufbringt, was z. B. durch Aufschleudern einer Lösung (spin-coating) geschehen kann, die Schicht dann thermisch vernetzt (Vorheizprozeß) und danach mit energiereicher Strahlung, im Falle von Röntgenstrahlen unter Verwendung einer Maske mit vorgegebenem Muster, bestrahlt und den bestrahlten Anteil mit einem Entwickler herauslöst. Durch die Bestrahlung mit energiereicher Strahlung werden sowohl Bindungen in den Hauptketten als auch Vernetzungsstellen zerstört. Dadurch wird das Resistmaterial an den belichteten Stellen im Entwickler löslich. Die Bestrahlung erfolgt vorzugsweise mit Röntgen-, Elektronenoder auch Ionenstrahlen. Als Entwickler kann ein organisches Lösungsmittel verwendet werden, z. B. ein zur Herstellung des Resistmaterials geeignetes Lösungsmittel oder Lösungsmittelgemisch. Erfindungsgemäß wird als Entwickler vorzugsweise Propanol-(2), ein Gemisch aus Propanol-(2) und Methylisobutylketon oder ein Gemisch aus Propanol-(2) und Methyläthylketon verwendet. Ein besonderer Vorteil der vorliegenden Erfindung liegt darin, daß man reines Propanol-(2) als Entwickler verwenden kann. Dadurch ist es möglich, häufig als Entwickler verwendete Lösungsmittelgemische zu vermeiden. Die Anwendung von Lösungsmittelgemischen als Entwickler ist oft problematisch. Die Entwicklungszeit entspricht der für Resists üblichen Entwicklungszeiten. Sie beträgt im allgemeinen etwa 1 bis 2 Minuten.

Mit den erfindungsgemäßen positiven Resistmaterialien werden Resists bereitgestellt, die neben einer hohen Empfindlichkeit auch eine sehr gute mechanische Stabilität und Haftfestigkeit aufweisen. Dadurch sind sie den bisher bekannten Resists auf Methacryl-Basis überlegen. Die erfindungsgemäßen Resists besitzen z. B. gegenüber einem Resist auf der Basis Polymethylmethacrylat eine um den Faktor 12 bis 20 höhere Empfindlichkeit. Sie weisen außerdem eine sehr hohe Lagerbeständigkeit bei Raumtemperatur auf. Aufgrund ihres hohen Kontrastfaktors sind die Resistmaterialien zur Abbildung feiner Strukturen geeignet. Die erfindungsgemäßen Resists eignen sich sehr gut für in der Röntgenlithographie übliche Substratmaterialien wie Silicium, Siliciumdioxid, Chrom, Aluminium, Titan, GaAs usw.

Die nachfolgenden Beispiele erläutern die Erfindung näher, ohne sie darauf zu beschränken.

**Beispiel 1**

Reinigung der Monomeren

Die zur Destillation benötigte Anlage wird sorgfältig von Wasser befreit und unter einem ständigen Stickstoffstrom gehalten.

100 g 2, 2, 3, 4, 4, 4-Hexafluorbutylmethacrylat werden zur Entstabilisierung im Scheidetrichter mit 20 ml 10 %iger Natronlauge, danach mit Wasser bis zur neutralen Reaktion gewaschen und nach Trennung der Phasen mit Calciumchlorid getrocknet. Der Ester wird anschließend bei einem Druck von 23 mbar und einer Temperatur von 60 bis 63°C über eine Kolonne abdestilliert. Die mittlere Fraktion wird für die Polymerisation verwendet.

**Beispiel 2**

Herstellung von 2, 2, 2-Trichloräthylmethacrylat durch azeotrope Umesterung

100 g (1 Mol) nicht entstabilisierter Methacrylsäuremethylester werden mit 224 g (1 Mol) Trichloräthanol, 5 g konzentrierter Schwefelsäure, 300 g Benzol und 5 g Hydrochinon versetzt. Das Gemisch wird in einer Azeotrop-Destillationsanlage 24 Stunden am Sieden gehalten. Das dabei entstehende Methanol wird abdestilliert. Nach Beendigung der Reaktion werden das Lösungsmittel (Benzol) und nicht umgesetzte Reste von Methacrylsäuremethylester und 2, 2, 2-Trichloräthanol durch Destillation vom Reaktionsgemisch abgetrennt. Das Produkt wird durch Vakuumdestillation fraktioniert. Die mittlere Fraktion (Kp. 74 - 76°C, 16 mbar) wird für die Copolymerisation verwendet.

**Beispiel 3**

Copolymerisation von 2, 2, 3, 4, 4, 4-Hexafluorbutylmethacrylat mit 2, 2, 2-Trichloräthylmethacrylat

Ein Bombenrohr wird unter Ausschluß von Feuchtigkeit und Sauerstoff mit 4,76 g nach Beispiel 1 gereinigtem 2, 2, 3, 4, 4, 4-Hexafluorbutylmethacrylat, 0,22 g 2, 2, 2-Trichloräthylmethacrylat (Beispiel 2) und 12 mg Benzoylperoxid gefüllt und abgeschmolzen. Die Polymerisation erfolgt bei einer Temperatur von 80°C innerhalb von 23 Stunden. Das Polymerisat wird in Methyläthylketon gelöst, mit Benzin ausgefällt und im Vakuum getrocknet. Die Ausbeute beträgt etwa 45 %.

Das mittlere Molekulargewicht wurde zu $\bar{M}_w = 2{,}0 \times 10^5$ bestimmt; $\bar{M}_w/\bar{M}_n = 2{,}6$.

**Beispiel 4**

**Anwendung**

Beschichtung von Substratoberflächen

Zur Beschichtung von Substratoberflächen löst man das nach Beispiel 3 hergestellte Copolymere in einem geeigneten Lösungsmittel auf und verdampft nach dem Auftragen der Lösung das Lösungsmittel, vorzugsweise unter Anwendung der spin-coating-Methode. Einen Film der Schichtdicke 1 µm erhält man beispielsweise, wenn man eine Lösung des Copolymeren in Methylisobutylketon (100 g/kg) bei 2000 Upm auf das Substrat aufschleudert. Die Filme werden anschließend 30 Minuten lang unter Stickstoff auf eine Temperatur zwischen 180 und 240° C erwärmt. Bei den nachfolgend beschriebenen Bestrahlungsversuchen wurden Filme verwendet, die auf 200° C erwärmt wurden.

**Strahlenempfindlichkeit und Kontrast**

Zur Ermittlung der Empfindlichkeit und des Kontrastfaktors wurden die Filme mit Synchrotronstrahlung bestrahlt. Als Strahlungsquelle diente der Speicherring Bessy (Berliner Elektronenspeicherring-Gesellschaft für Synchrotronstrahlung, Berlin) mit einer Elektronenenergie von 750 MeV. Die Wellenlänge des Energiemaximums der Synchrotronstrahlung hinter einem 7,5 µm Kaptonfilter und 9 µm Silicium lag bei;$\lambda_{max}$ = 0,8 nm entsprechend 1,55 keV. Die Entwicklung erfolgte bei 23° C in Propanol-(2). Die Entwicklungszeit betrug 90 Sekunden. Für die Bestrahlungsversuche ergab sich unter Verwendung von Filmen der anfänglichen Schichtdicke $d_o$ = 0,8 µm eine Empfindlichkeit $D_s$ = 25 ± + 5 mJ/cm$^2$, d. h. das Copolymere besitzt eine etwa 20 mal höhere Empfindlichkeit als Polymethylmethacrylat (PMMA). Der Kontrastfaktor beträgt $\gamma$ = 4,5. Im Falle von PMMA ist $\gamma$ = 2,9.

Fig. 1 zeigt die relative Abnahme der Schichtdicke als Funktion der Bestrahlungsdosis (Gradationskurve) für das Copolymere aus 2, 2, 3, 4, 4, 4-Hexafluorbutylmethacrylat und 2, 2, 2-Trichloräthylmethacrylat (5,3 Mol-%). Anfängliche Schichtdicke $d_o$ = 0,8 µm, $d_D$: nach Bestrahlung und Entwicklung verbleibende Schichtdicke, Entwickler: Propanol-(2), Entwicklungszeit: 90 Sekunden.

**Haftfestigkeit**

Haftfestigkeitsuntersuchungen wurden mit Hilfe der Gitterschnittprüfmethode gemäß DIN 53151 unter Verwendung des Gitterschnittprüfgerätes der Firma Erichsen, Typ 295, an 1 µm dicken Resistfilmen durchgeführt. Als Substrat dienten Objektträger aus Glas. Die an Filmen aus Poly-2, 2, 3, 4, 4, 4-hexafluorbutylmethacrylat-co-2, 2, 2-trichloräthylmethacrylat (95: 5 Mol-%), Poly-2, 2, 3, 4, 4, 4-hexafluorbutylmethacrylat (FBM 110, Daikin Kogyo Co.) und Polymethylmethacrylat (Esschem) erhaltenen Ergebnisse sind in Tabelle 1 zusammengefaßt. Während im Falle des Homopolymeren FBM 110 der Gt-O-B-Wert 0 % ist, d. h. alle durch den Gitterschnitt erzeugten Quadrate beträchtlich beschädigt sind, beträgt der Gt-O-B-Wert im Falle des Copolymeren MFCE 98 %, d. h. nur ein sehr kleiner Anteil der Quadrate zeigt ausgeprägte Kantenschäden.

Der Vergleich mit PMMA ergibt, daß das Homopolymere FBM 110 eine schlechtere Haftfestigkeit hat als PMMA, sofern die Vorheiz-Temperatur (prebaking) - wie in der Praxis bei dieser Substanz üblich - 140° C beträgt.

Bei 200° C vorgeheizte Filme aus FBM 110 verhalten sich hinsichtlich der Haftfestigkeit ähnlich wie Filme aus PMMA, die bei 140° C vorgeheizt wurden.

Tabelle 1: Haftfestigkeit von Resistfilmen auf Glas, gemessen mit Hilfe der Gitterschnittprüfmethode gemäß DIN 53151

| Gitterschnitt-kennwert[a] | Polymere | | | |
|---|---|---|---|---|
| | PMMA[b] | FBM 110[c] A | FBM 110[c] B | MFCE[d] |
| Gt-0-B | 0 % | 0 % | 0 % | 98 % |
| Gt-1-B | 96 % | 72 % | 99 % | 2 % |
| Gt-2-B | 4 % | 28 % | 1 % | 0 % |

a) Beim Gitterschnitt wird eine bestimmte Anzahl von Quadraten der Abmessung 1 x 1 mm erzeugt. Ermittelt wird der Anteil der Quadrate, der unbeschädigt geblieben ist (Gt-O-B), bzw. der Anteile Quadrate, deren Fläche durch Absplittern um bis zu 5 g (Gt-1-B) und um 5 bis 15 % (Gt-2-B) abgenommen hat.

b) Polymethylmethacrylat, prebaking: 150 °C, 30 min.

c) Poly-2, 2, 3, 4, 4, 4-hexafluorbutylmethacrylat, prebaking: 140° C, 30 min (A), 200° C, 30 min (B).

d) Poly-2, 2, 3, 4, 4, 4-hexafluorbutylmethacrylat-co-2, 2, 2-trichloräthylmethacrylat (95: 5), prebaking: 200° C, 30 min.

**Patentansprüche:**

1. Positives Resistmaterial bestehend aus einem in einem organischen Lösungsmittel löslichen, thermisch vernetzbaren Copolymeren aus Fluoralkylmethacrylat und Chloralkylmethacrylat,

<u>dadurch gekennzeichnet</u>,

daß das Copolymere die allgemeine Formel

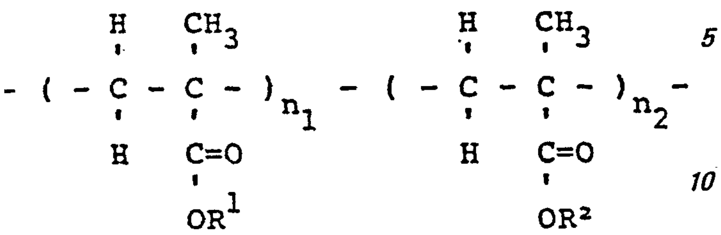

besitzt, worin $R^1$ eine ganz oder teilweise fluorierte Alkylgruppe mit 2 bis 6 Kohlenstoffatomen, $R^2$ eine teilweise chlorierte Alkylgruppe mit 2 bis 6 Kohlenstoffatomen und einer ω-Trichlormethylgruppe darstellt, der Polymerisationsgrad $n = n_1 + n_2$ zwischen 300 und 3000 und der Molenbruch $n_2/n$ zwischen 0,02 und 0,20 liegt.

2. Resistmaterial nach Anspruch 1, dadurch gekennzeichnet, daß die fluorierte Alkylgruppe eine Hexafluoralkylgruppe ist.

3. Resistmaterial nach Anspruch 2, dadurch gekennzeichnet, daß die fluorierte Alkylgruppe 2, 2, 3, 4, 4, 4-Hexafluorbutyl ist.

4. Resistmaterial nach einem der Ansprüche 1 bis 3, dadurch gekennzeichnet, daß die chlorierte Alkylgruppe 2, 2, 2-Trichloräthyl ist.

5. Resistmaterial nach einem der Ansprüche 1 bis 4, dadurch gekennzeichnet, daß das organische Lösungsmittel Methyläthylketon, Methylisobutylketon und/oder Butylacetat ist.

6. Verfahren zur Herstellung eines thermisch vernetzbaren, positiven Resistmaterials, dadurch gekennzeichnet, daß man ein wie in den Ansprüchen 1 bis 5 definiertes Copolymeres in einem organischen Lösungsmittel löst.

7. Verfahren nach Anspruch 6, dadurch gekennzeichnet, daß man das Copolymere in Methyläthylketon, Methylisobutylketon und/oder Butylacetat löst.

8. Verwendung eines Resistmaterials nach einem der Ansprüche 1 bis 5 als Positivresist zur Strukturierung von Werkstoffoberflächen.

9. Verwendung nach Anspruch 8, dadurch gekennzeichnet, daß man das Resistmaterial in dünner Schicht auf ein Substrat aufbringt, thermisch vernetzt, mit energiereicher Strahlung nach einem gewünschten Muster bestrahlt und den bestrahlten Anteil mit einem Entwickler herauslöst.

10. Verwendung nach Anspruch 9, dadurch gekennzeichnet, daß man das Resistmaterial vor der Bestrahlung innerhalb einer Zeit von 30 bis 90 Minuten bei einer Temperatur von 180 bis 250°C vernetzt.

11. Verwendung nach einem der Ansprüche 8 bis 10, dadurch gekennzeichnet, daß man mit Röntgen-, Elektronen- oder Ionenstrahlen bestrahlt.

12. Verwendung nach einem der Ansprüche 8 bis 11, dadurch gekennzeichnet, daß man mit Propanol-(2), einem Gemisch aus Propa-nol-(2) und Methylisobutylketon oder einem Gemisch aus Propanol-(2) und Methyläthylketon entwickelt.

**Claims**

1. Positive resist material consisting of a thermally cross-linkable co-polymer of fluoroalkyl methacrylate and chloroalkyl methacrylate which is soluble in an organic solvent, characterised in that the co-polymer has the general formula:

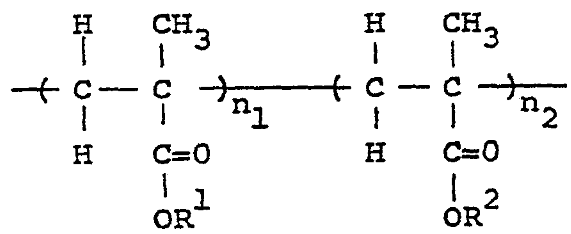

wherein $R^1$ represents a wholly or partly fluorinated alkyl group with 2 to 6 carbon atoms, $R^2$ partly chlorinated alkyl group with 2 to 6 carbon atoms and an ω-trichloromethyl group, the degree of polymerisation $n = n_1 + n_2$ lies between 300 and 3000 and the mole fraction $n_2/n$ lies between 0.02 and 0.20.

2. Resist material according to claim 1, characterised in that the fluorinated alkyl group is a hexafluoroalkyl group.

3. Resist material according to claim 2, characterised in that the fluorinated alkyl group is 2, 2, 3, 4, 4, 4-hexafluorobutyl.

4. Resist material according to one of claims 1 to 3, characterised in that the chlorinated alkyl group is 2, 2, 2-trichloroethyl.

5. Resist material according to one of claims 1 to 4, characterised in that the organic solvent is methyl ethyl ketone, methyl isobutyl ketone and/or butyl acetate.

6. Process for the production of a thermally cross-linkable, positive resist material, characterised in that one dissolves a co-polymer as defined in claims 1 to 5 in an organic solvent.

7. Process according to claim 6, characterised in that one dissolves the co-polymer in methyl ethyl ketone, methyl isobutyl ketone and/or butyl acetate.

8. Use of a resist material according to one of claims 1 to 5 as positive resist for the structuring of work material surfaces.

9. Use according to claim 8, characterised in

that one applies the resist material in a thin layer to a substrate, thermally cross-links, irradiates with energy-rich radiation according to a desired pattern and dissolves out the irradiated part with a developer.

10. Use according to claim 9, characterised in that, before the irradiation, one cross-links the resist material within a time of 30 to 90 minutes at a temperature of 180 to 250°C.

11. Use according to one of claims 8 to 10, characterised in that one irradiates with X-ray, electron or ion radiations.

12. Use according to one of claims 8 to 11, characterised in that one develops with propan-2-ol, a mixture of propan-2-ol and methyl isobutyl ketone or a mixture of propan-2-ol and methyl ethyl ketone.

## Revendications

1. Matériau résistif positif constitué d'un copolymère de méthacrylate de fluoroalcoyle, réticulable thermiquement, soluble dans une solution organique, caractérisé en ce que le copolymère possède la formule générale

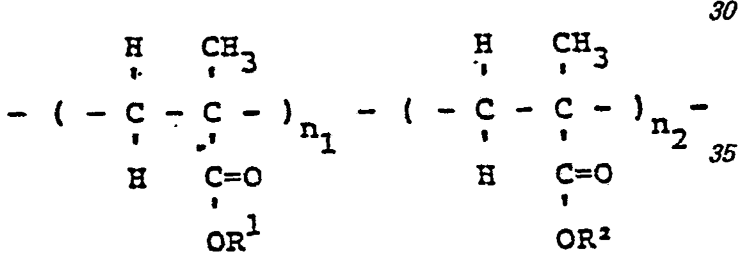

dans laquelle $R^1$ représente un groupe alcoyle entièrement ou partiellement fluoré avec 2 à 6 atomes de carbones, $R^2$ un groupe alcoyle partiellement chloré avec 2 à 6 atomes de carbone et un groupe ω-trichlorométhyle, le degré de polymérisation $n = n_1 + n_2$ se situant entre 300 et 3000 et la fraction de mole $n_2/n$ entre 0,02 et 0,20.

2. Matériau résistif selon la revendication 1, caractérisé en ce que le groupe alcoyle fluoré est un groupe hexafluoroalcoyle.

3. Matériau résistif selon la revendication 2, caractérisé en ce que le groupe alcoyle fluoré est le 2, 2, 3, 4, 4, 4-hexafluorobutyle.

4. Matériau résistif selon une des revendications 1 à 3, caractérisé en ce que le groupe alcoyle chloré est le 2, 2, 2-trichloroéthyle.

5. Matériau résistif selon une des revendications 1 à 4, caractérisé en ce que le solvant organique est la méthyléthylcétone, la méthylisobutylcétone et/ou de l'acétate de butyle.

6. Procédé pour la préparation d'un matériau résistif positif réticulable thermiquement, caractérisé en ce que l'on dissout un copolymère tel que défini dans les revendications 1 à 5 dans un solvant organique.

7. Procédé selon la revendication 6, caractérisé en ce que l'on dissout le copolymére dans la méthyléthylcétone, la méthylisobutylcétone et/ou l'acétate de butyle.

8. Utilisation d'un matériau résistif selon une des revendications 1 à 5, en tant que résistif positif pour la structuration des surfaces du matériau.

9. Utilisation selon la revendication 8, caractérisée en ce que l'on applique le matériau résistif sous forme de couche fine sur un substrat, on réticule thermiquement, on irradie par irradiation à haute énergie selon une configuration désirée et que l'on enlève par dissolution la partie irradiée au moyen d'un révélateur.

10. Utilisation selon la revendication 9, caractérisée en ce que l'on réticule le matériau résistif avant l'irradiation pendant 30 à 90 minutes à une température de 180 à 250°C.

11. Utilisation selon une des revendications 8 à 10, caractérisée en ce que l'on irradie au moyen de rayons X, d'électrons ou d'ions.

12. Utilisation selon une des revendications 8 à 11, caractérisée en ce que l'on procède au développement au moyen de propanol-(2) d'un mélange de propanol-(2) et de méthylisobutylcétone ou d'un mélange de propanol-(2) et de méthyléthylcétone.

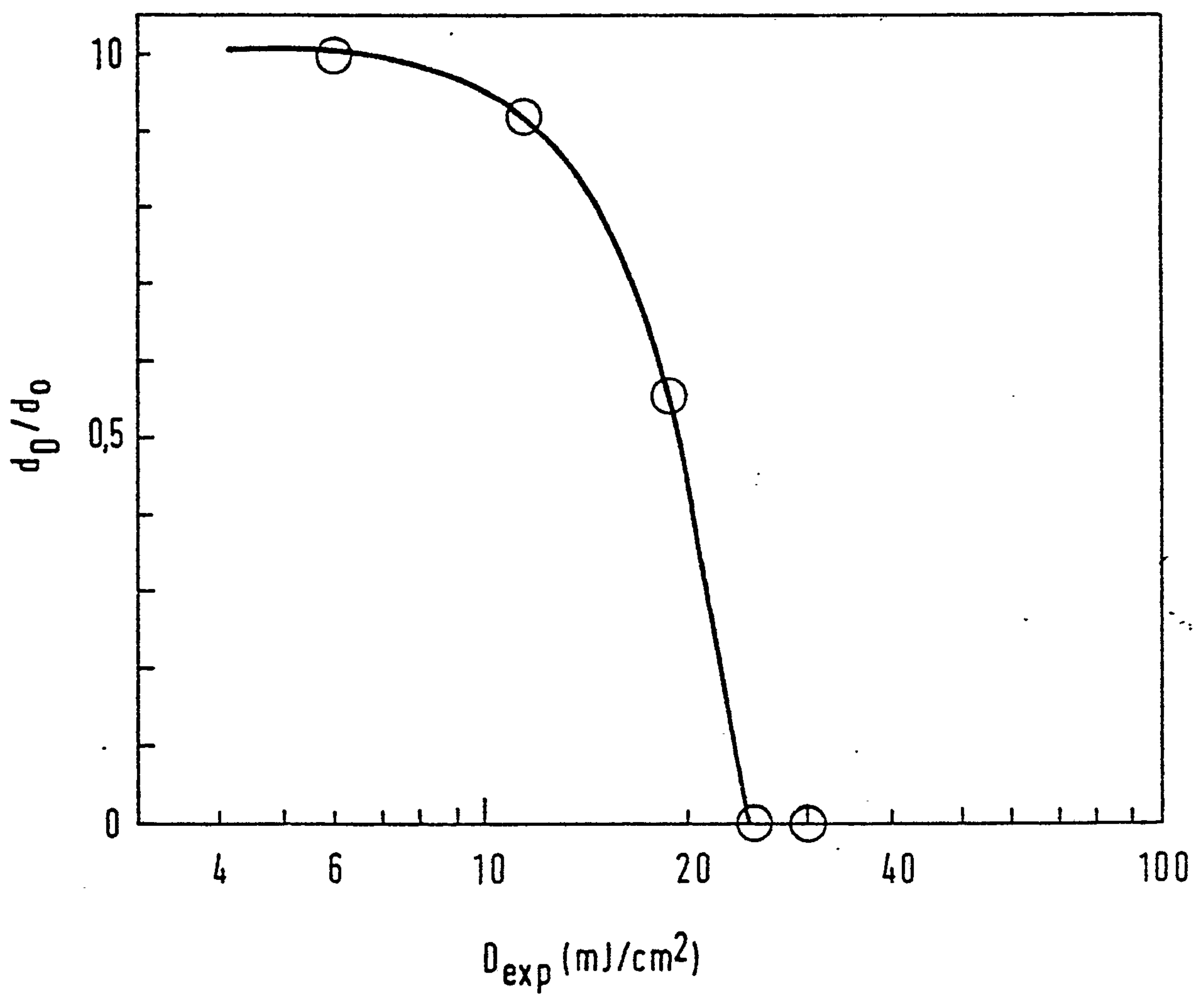
10
0,5
0
$d_0/d_o$
4
6
10
20
40
100
$D_{exp}$ (mJ/cm2)